(19) Europäisches Patentamt
European Patent Office
Office européen des brevets

(11) **EP 2 471 202 B1**

(12) **EUROPÄISCHE PATENTSCHRIFT**

(45) Veröffentlichungstag und Bekanntmachung des Hinweises auf die Patenterteilung:
**27.08.2014 Patentblatt 2014/35**

(21) Anmeldenummer: **10787696.3**

(22) Anmeldetag: **24.11.2010**

(51) Int Cl.:
*H04B 10/69* (2013.01)     *H01L 31/02* (2006.01)

(86) Internationale Anmeldenummer:
**PCT/EP2010/007281**

(87) Internationale Veröffentlichungsnummer:
**WO 2011/063991 (03.06.2011 Gazette 2011/22)**

(54) **SCHALTUNGSANORDNUNG ZUM EINSTELLEN DES SPANNUNGSPOTENTIALS AM HF-AUSGANG EINES PIN- PHOTOEMPFÄNGERS UND PHOTOEMPFÄNGERANORDNUNG**

CIRCUIT ASSEMBLY FOR SETTING THE VOLTAGE POTENTIAL AT THE RF OUTPUT OF A PIN PHOTORECEIVER AND PHOTORECEIVER ASSEMBLY

CIRCUITERIE POUR RÉGLER LE POTENTIEL DE TENSION À LA SORTIE HF D'UN PHOTORÉCEPTEUR PIN ET SYSTÈME DE PHOTORÉCEPTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.11.2009 DE 102009056059**

(43) Veröffentlichungstag der Anmeldung:
**04.07.2012 Patentblatt 2012/27**

(73) Patentinhaber: **Fraunhofer-Gesellschaft zur Förderung der angewandten Forschung e.V.
80686 München (DE)**

(72) Erfinder: **BACH, Heinz-Gunter
14163 Berlin (DE)**

(74) Vertreter: **Pfenning, Meinig & Partner GbR
Patent- und Rechtsanwälte
Joachimstaler Strasse 12
10719 Berlin (DE)**

(56) Entgegenhaltungen:
**US-A1- 2009 238 582**

- **HEINZ-GUNTER BACH ET AL: "Design and Fabrication of 60-Gb/s InP-Based Monolithic Photoreceiver OEICs and Modules", IEEE JOURNAL OF SELECTED TOPICS IN QUANTUM ELECTRONICS, IEEE SERVICE CENTER, PISCATAWAY, NJ, US, Bd. 8, Nr. 6, 1. November 2002 (2002-11-01), XP011066205, ISSN: 1077-260X**

**Beschreibung**

Die Erfindung betrifft eine Schaltungsanordnung zum Einstellen des Spannungspotentials am HF-Ausgang eines pin-Photoempfängers und eine Photoempfängeranordnung.

Ultraschnelle Photoempfänger, die im seriellen 100 Gbit/s Datenratenbereich arbeiten und für die Gleichspannungskopplung zu nachfolgenden elektronischen Schaltkreisen, z.B. einem Demultiplexer-Schaltkreis ausgebildet sind, bestehen im einfachsten Fall aus einer pin-Photodiode mit rückseitiger Bias-Einspeisung, aber auch aus einer pin-Photodiode, integriert mit einem Wanderwellenverstärker (TWA = Travelling-Wave Amplifier). Die Photoempfänger sind üblicherweise als optoelektronische integrierte Schaltkreise (OEIC) ausgebildet, die mit einem weiteren integrierten Schaltkreis, z.B. dem oben erwähnten Demultiplexer, verbunden sind. Allerdings kann eine Folgeelektronik auch ein Sampling-Schaltkreis eines Sampling-Oszilloskops oder ein Wanderwellenverstärker oder dergleichen sein. Im Folgenden wird als Folgeelektronik zur Erläuterung ein Demultiplexer gewählt.

Der Photoempfänger wandelt einen optischen Datenstrom, der über eine Glasfaser in die Photodiode des OEIC eingekoppelt wird, in ein elektrisches Ausgangssignal gleicher Datenrate um, das als hochfrequentes Ausgangssignal an den nachgeschalteten Demultiplexer weitergegeben wird. Dieser demultiplext, hier im Beispiel das 100 Gbit/s elektrische Datensignal in zwei 50 Gbit/s Datensignale, die an seinen zwei Ausgängen erscheinen.

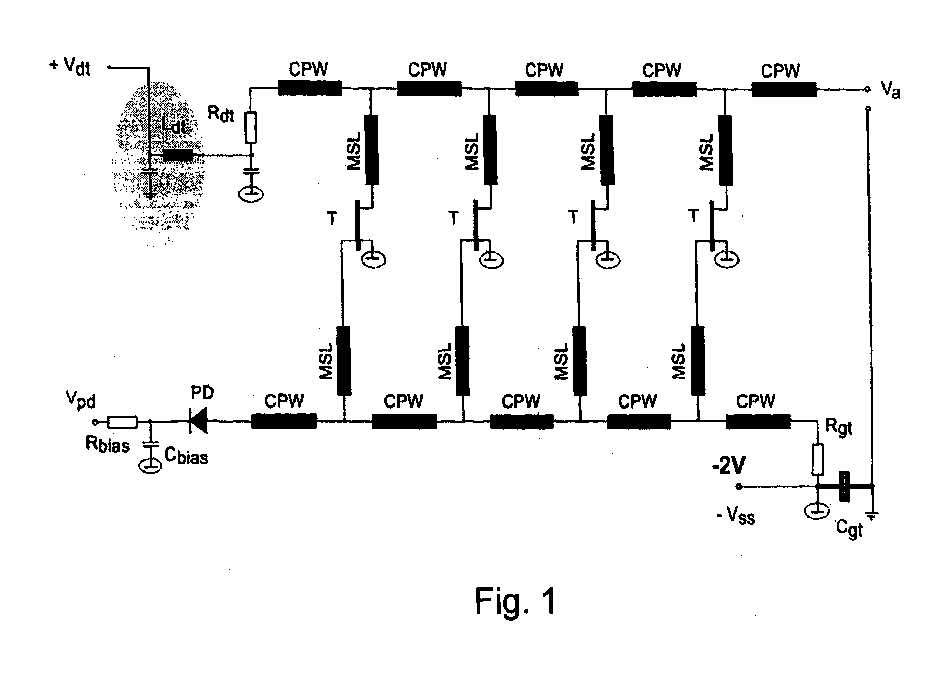

Wenn der Photoempfänger als pinTWA-Photoempfänger entsprechend Fig. 1 ausgebildet ist, ist der Wanderwellenverstärker auf dem Chip mit der Photodiode PD und ihrer Beschaltung mit einem Vorspannwiderstand $R_{bias}$ und einem Abblock-Kondensator $C_{bias}$ integriert, so dass das Photodiodensignal bereits auf dem Chip verstärkt wird. Der Wanderwellenwellenverstärker, der in der Veröffentlichung "Design and Fabrication of 60 Gb/s InP-Based Monolithic Photoreceiver OEICs and Modules", Bach et al., IEEE Journal of Selected Topics in Quantum Electronics, Vol. 8, No. 6, 2002, Seiten 1445-1450, offenbart ist, weist eine Mehrzahl von parallel geschalteten Transistoren auf, im vorliegenden Fall FETs, aber auch bipolare Transistoren sind möglich, deren Gate- und Drainanschlüsse jeweils über Mikrostreifenleitungen MSL mit koplanaren Wellenleiterelementen CPW verbunden sind. Ein Ende der Kette von koplanaren Leitungselementen CPW, die mit den Gateanschlüssen der Transistoren über die Mikrostreifenleitungselemente MSL verbunden ist, ist mit der Photodiode PD und das andere Ende über einen Abschlusswiderstand $R_{gt}$ mit der negativen Betriebsspannung $-V_{ss}$ bzw. über einen Abblockwiderstand $C_{gt}$ auch HF-technisch mit Ground oder

Erde verbunden. Eine weitere Kette von Wellenleiterelementen CPW, die mit den Drainschlüssen der FETs T verbunden ist, ist einerseits mit einem integrierten Drain-Abschlusswiderstand $R_{dt}$ und über eine chipexterne Bonddrahtinduktivität $L_{dt}$ mit einem positiven Spannungsversorgungsanschluss $+V_{dt}$ und andererseits mit dem Signalausgang verbunden, an den beispielsweise ein Demultiplexer angeschlossen ist. Der pinTWA-Chip wird an dem positiven Anschluss $+V_{dt}$ und einem negativen Anschluss $-V_{ss}$ (negative bias) spannungs/stromversorgt. Am Ausgang des Photoempfängers liegt neben dem hochfrequenten Ausgangssignal bzw. Eingangssignal für den Demultiplexer ein Gleichspannungspotential $V_a$ vor, das ebenfalls an dem elektrischen Eingang des Demultiplexers liegt. Der Demultiplexer hat in vielen Fällen das beste Schaltverhalten, wenn die mittlere DC-Eingangsspannung um 0 V liegt, wobei sein maximaler Spannungshub in einem sicheren Arbeitsbereich von typisch -0,6 V bis +0,4 V liegen soll.

Nach dem Stand der Technik sind die Demultiplexer-Schaltkreise an ihrem Eingang äußerst empfindlich auf Überspannungen, da bei den hohen Schaltfrequenzen die empfindlichen Eingangstransistoren kaum mit Schutzschaltungen gegen Spannungsspitzen versehen werden können, die sofort die Grenzfrequenz vermindern würden. Demzufolge muss der Anwender, der einem Demultiplexer IC einen Photoempfänger-OEIC vorschaltet, dafür Sorge tragen, dass derartige Spannungsspitzen und auch mögliche DC-Offsets innerhalb der genannten Fenster bleiben, ansonsten ist mit einem Defekt des Demultiplexers zu rechnen. Die Photoempfänger, insbesondere die pinTWA-Photoempfänger und die Demultiplexer ICs sind derzeit im hohen Gbit/s-Bereich sehr teure Schaltkreise.

Der Ausgang des Photoempfängers, der im Falle eines pinTWA-Photoempfängers auch in Kaskodenschaltung vorliegen kann, muss somit mit dem Eingang des Demultiplexer-ICs verbunden werden. Bei dem pinTWA-Photoempfänger, dessen Potential des hochfrequenzelektrischen Ausgangs über eine geeignete Einstellung der beiden Versorgungsspannungen $+V_{dt}$ und $-V_{ss}$ bereits um 0 V herum einstellbar ist, kommt es im praktischen Betrieb darauf an, zur Vermeidung der möglichen Zerstörung des Demultiplexers das Spannungspotential am Ausgang des Photoempfängers, bzw. am Eingang des Demultiplexers messen zu können, um die Versorgungsspannungen des pinTWA-Photoempfängers auch im dynamischen Fall des Ein- und Ausschaltens, wie auch im Betrieb stets innerhalb der Spannungsmargen eines sicheren Arbeitsbereichs des Demultiplexers zu halten.

Im Falle eines einfachen Photoempfängers in Form eines Photodiodenchips sind zwar ein oder mehrere Bias-Terminals vorgesehen, die die Anlegung einer Bias-Spannung an die Diode ermöglichen, in dieser einfachen Ausführungsform würde jedoch bei DC-Kopplung des Signal-HF-Ausgangs der Diode mit dem Demultiplexer Schaltkreis der mittlere Photostrom aus der Diode zu einer Arbeitspunktverschiebung des Demultiplexers, in der Regel in positive Richtung, führen, wodurch der optimale Arbeitsbereich des Demultiplexers verlassen wird.

Hinsichtlich des pinTWA-Photoempfängers müsste zur Vermeidung der genannten Nachteile ein konzertiertes manuelles Hochfahren der beiden Versorgungsspannungen $V_{dt}$ und $-V_{ss}$ unter der Maßgabe erfolgen, dass der HF-Ausgang des Photoempfängers stets um 0 V gehalten wird. Um alle Risiken transienter Überspannungsimpulse auszuschließen und auch um das Ausgangspotential des Photoempfängers messen zu können, hat sich die Zwischenschaltung eines so genannten Bias-T in die Verbindungsleitung zwischen Photoempfänger und Demultiplexer eingebürgert, das einen in der Signalleitung liegenden Kondensator und einen zu einem Einstellanschluss führenden Widerstand bzw. eine Induktivität aufweist. Auch bei einem reinen pin-Photoempfänger ist eine solche Anwendung eines Bias-Ts bekannt. Diese Bias-Ts müssen für Grenzfrequenzen im 100 GHz-Bereich tauglich sein und auch untere Grenzfrequenzen bis herab zu mindestens 100 KHz erreichen, um damit sowohl die Signalbandbreite zu übertragen, wie auch den so genannten Rahmentakt, der bis in den 10 KHz-Bereich herunterreichen kann. Sie sind damit ebenfalls sehr kostenaufwendig und außerdem bedämpfen sie das Hochfrequenz-Ausgangssignal des Photoempfängers um etwa 2 dB und machen damit einen Teil seiner Verstärkung (10 dB) zunichte.

Wenn in Entwicklungsvorstufen beide Komponenten, Photoempfänger und Demultiplexer, in separaten Gehäusen vorliegen, ist ein Dazwischenschalten eines Bias-Ts leicht möglich, wenn auch im Rahmen der zuvor angeführten Nachteile. In fortgeschritten Gehäuseszenarien, im so genannten Co-Packaging, werden jedoch beide Komponenten, Photoempfänger und Demultiplexer in ein einziges Gehäuse eingebracht, um einerseits Gehäusekosten einzusparen und andererseits auch die Signaldämpfung zwischen beiden integrierten Schaltungen zu reduzieren, die sich sonst zusätzlich durch die notwendigen HF-Verbindungsstecker und - leitungen ergeben, die bei ca. 2 dB pro Gehäuse liegen. Weiterhin verlassen in diesem bevorzugten Co-Packaging-Design nur mittelfrequente Signale das Gehäuse, so dass Verbindungskosten für Höchstfrequenzstecker eingespart werden. Liegt dieser bevorzugte Co-Packaging-Fall vor, werden beide integrierte Schaltungen in einem Gehäuse dichtest zusammengepackt und direkt mit ultrakurzen Bonddrähten verbunden, so dass dann aber kein Bias-T mehr eingefügt werden kann. Damit entfällt auch die betriebsbegleitende Messmöglichkeit der Ausgangsgleichspannung $V_a$ des Photoempfängers bzw. der Eingangsspannung des Demultiplexers.

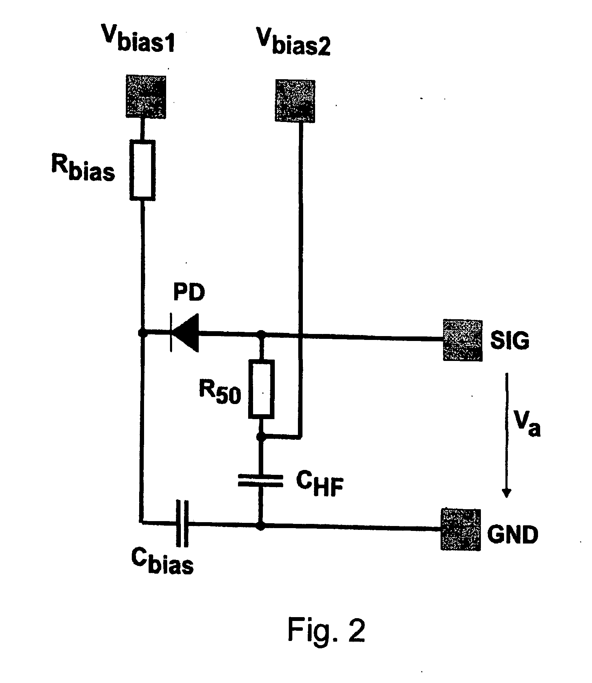

Im Fall des Photoempfängers als reiner Photodiodenchip wurde als Abhilfe eine so genannte Bias-Feeding-Photodiode entworfen, die von der Anmelderin zum Patent angemeldet wurde und die in der Fig. 2 schematisch dargestellt ist. Dieser Photoempfänger weist einen Anschluss $V_{bias1}$ auf, der über einen Widerstand $R_{bias}$ mit der Kathode einer Photodiode PD verbunden ist. Die Anode der Photodiode PD ist an einen Signalausgang SIG angeschlossen, wobei zwischen Signalausgang SIG und Erde GND hochfrequenztechnisch ein Abschlusswiderstand $R_{50}$ geschaltet ist. Ein Abblockkondensator $C_{bias}$ liegt zwischen Kathode der Photodiode PD und Erde. Der Photoempfänger bzw. die Photodiode PD wird über den Anschluss $V_{bias1}$ mit einer Sperrspannung versorgt und der Widerstand $R_{50}$ dient der Verringerung der RC-Konstante zur Erzielung höherer Grenzfrequenzen und zur Vermeidung von Reflexionen, die von einer nachgeschalteten Elektronik auf den Photoempfänger zulaufen könnten und bei erneuter Reflexion die Signalintegrität degradieren würden.

Die neuartige Bias-Feeding-Photodiode weist nun zusätzlich zu dem ersten Bias-Anschluss $V_{bias1}$ einen zweiten Bias-Anschluss -$V_{bias2}$ und einen weiteren Abblockkondensator $C_{HF}$ zur HF-technischen Erdung des Abschlusswiderstands auf. Wie aus der Schaltung zu erkennen ist, liegt der Abblockkondensator $C_{HF}$ zwischen Abschlusswiderstand $R_{50}$ und Erde GND, wobei der zweite Bias-Anschluss -$V_{bias2}$ von dem Verbindungspunkt beider Elemente nach außen geführt ist. Das Minus an dem zweiten Bias-Anschuss -$V_{bias2}$ soll andeuten, dass eine gegenläufige Stromeinspeisung am Anschluss stattfindet, wodurch potentialmäßig dem Photostrom entgegengewirkt wird. Üblicherweise ist an dem Anschluss $V_{bias1}$, der auch in zwei Teilanschlüsse aufgeteilt werden kann, eine positive Bias-Spannung anzulegen und die Spannung am Anschluss -$V_{bias2}$ soll betragsmäßig kleiner oder negativ zu der am Anschluss $V_{bias1}$ sein. Bei der Wahl der richtigen Spannungsamplitude am Spannungsanschluss -$V_{bias2}$ ist es möglich, den Eingang der Folgeelektronik, hier des Demultiplexers auf 0 V einzustellen oder auch auf ein beliebiges leicht negatives oder positives Potential, wenn dies der Demultiplexer erfordert.

Der Erfindung liegt somit die Aufgabe zugrunde, eine Schaltungsanordnung zum automatischen Einstellen eines Ausgangspotentials $V_a$ am HF-Ausgang eines Photoempfängers mit einem nachgeschalteten Elektronikkreis sowie eine Photodiodenempfängeranordnung mit einem Photodiodenempfänger und einer solchen Schaltungsanordnung zu schaffen, mit denen es in einfacher Weise möglich ist, das Eingangsspannungspotential $V_a$ eines dem Photoempfänger nachfolgenden Schaltkreises, wie eines Demultiplexers, eines Verstärkers oder eines Sampling-Schaltkreises, auf einen vorgegebenen Wert, vorzugsweise 0V zu regeln, wobei eine direkte DC-Kopplung zwischen Photoempfänger und nachgeschaltetem elektronischen Schaltkreis derart realisierbar sein soll, dass auf ein Bias-T verzichtet werden kann und ein Co-Packaging möglich wird. Außerdem soll eine kostengünstige Ausführung erzielt werden.

Diese Aufgabe wird erfindungsgemäß durch die kennzeichnenden Merkmale des Hauptanspruchs in Verbindung mit den Merkmalen des Oberbegriffs sowie durch die Merkmale des Patentanspruchs 10 gelöst.

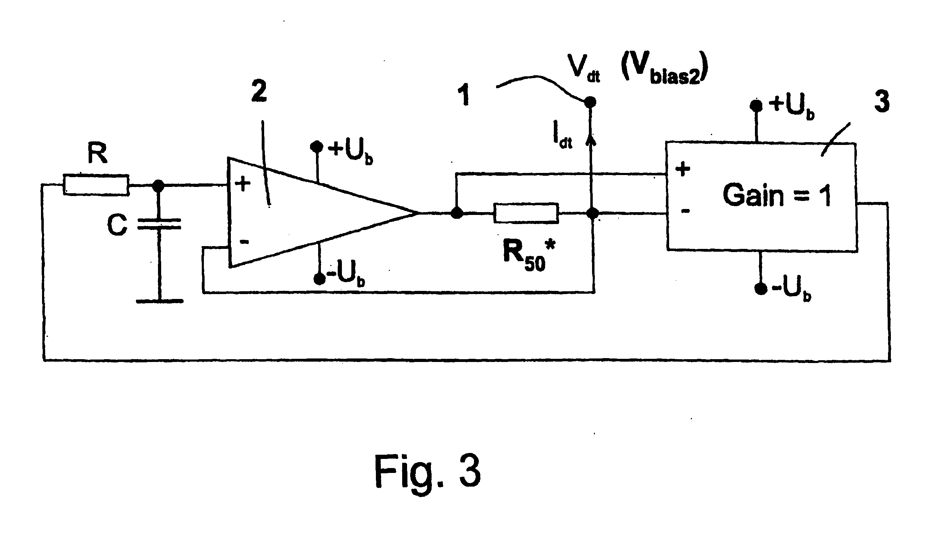

Dadurch, dass die erfindungsgemäße Schaltungsanordnung (siehe Fig. 3) eine Regelschleife zum Erzeugen und Regeln der Spannung einer Spannungsversorgung, die über den jeweiligen ohmschen Abschlusswiderstand das Ausgangspotential des Photoempfängers beeinflusst, aufweist, die einen ohmschen Nachbildungswiderstand, der an den ohmschen Abschlusswiderstand angeglichen ist, weiterhin Mittel zur Messung einer Spannungsdifferenz und zum Reproduzieren der Spannungsdifferenz als Spannungspotential am Ausgangsanschluss der Regelschleife umfasst, kann ein Photoempfänger als optoelektronischer integrierter Schaltkreis direkt mit einer integrierten Folgeelektronik, beispielsweise mit einem Demultiplexer DC-gekoppelt verbunden werden, wobei eine exakte Kontrolle des Spannungspotentials $V_a$ des Ausgangs des Photoempfängers bzw. des Eingangs der Folgeelektronik gegeben ist, ohne dass an diesem empfindlichen Punkt Messanzapfungen erforderlich sind. Dabei wird unter Spannung der Spannungsversorgung einerseits bei einem pinTWA-Photoempfänger eine Betriebsspannung $V_{dt}$ des zugehörigen Wanderwellenverstärkers verstanden, während bei einer Ausführung als reiner Photoempfänger mit pin-Photodiode die Bias-Spannung gemeint ist, die an den zweiten Bias-Anschluss $-V_{bias2}$ angelegt wird. Eine sichere Inbetriebnahme einer DC-gekoppelten pinTWA-Photoempfänger-Demultiplexer-Kombination wird mit Hilfe der erfindungsgemäßen Schaltungsanordnung mit Regelschaltung überhaupt erst möglich, da beim Herauf- und Herunterfahren das Ausgangspotential automatisch auf 0 V gehalten wird und keine transienten Überspannungsimpulse auftreten. Zusätzlich zum sicheren Einschalten eines Photoempfängers mit integriertem Wanderwellenverstärker stabilisiert die Regelungsschaltung das Eingangspotential des nachfolgenden Demultiplexers bzw. der Folgeelektronik auch gegen langsam veränderliche Photoströme, respektive optischen Leistungsschwankungen am Photoempfängereingang, so dass eine automatische Schaltschwellennachführung im Demultiplexer entfallen kann. Dies gilt auch für das Ausführungsbeispiel einer reinen Photodioden-Demultiplexerintegration, wenn die Regelungsschaltung das zweite Bias-Terminal der Photodiode so nachführt, dass für quasi beliebige Photoströme das Demultiplexer-Eingangspotential $V_a$ auf 0 V bzw. auf einer optimalen Schaltschwelle $V_{a,\,preset}$ gehalten wird.

Weiter vorteilhaft ist, dass durch die Möglichkeit des Weglassens eines Höchstfrequenz-Bias-Ts nennenswerte hochfrequente Signaldämpfungen im Bereich von ca. 6 dB vermieden werden und zusätzlich Kosten gespart werden. Beide integrierte Schaltungen, nämlich Photoempfänger und Folgeelektronik bzw. Demultiplexer, können dann in einem einzigen Gehäuse dichtest gepackt in Co-Packaging aufgebaut und sicher betrieben werden.

Durch die in den Unteransprüchen angegebenen Maßnahmen sind vorteilhafte Weiterbildungen und Verbesserungen möglich.

Besonders vorteilhaft ist es, wenn der geschlossene Regelkreis einen Spannungsfolger, den Nachbildungswiderstand und einen Differenzverstärker zum Messen der Spannungsdifferenz über den Nachbildungswiderstand aufweist. Dabei ist das Ausgangssignal des Differenzverstärkers mit Verstärkungsfaktor 1 dem Spannungsfolger als Steuergröße an einen seiner Eingänge zuführbar, und der andere Eingang ist vorzugsweise mit dem Ausgangsanschluss der Regelschleife verbunden. Eine derartige Schaltung hat den Vorteil, dass preisgünstige integrierte Standard-Siliziumschaltungen verwendet werden können, so dass die gesamte Regelschaltung in einfacher Weise und kostengünstig aufgebaut werden kann.

Der Nachbildungswiderstand ist vorzugsweise einerseits mit dem Ausgang des Spannungsfolgers und andererseits mit dem Ausgangsanschluss der Regelschleife verbunden, so dass ungeachtet der Höhe des Spannungsabfalls über dem Nachbildungswiderstand aufgrund der eigenen Gegenkopplung des Spannungsfolgers das von dem Differenzverstärker an den einen Eingang des Spannungsfolgers gelieferte Potential dieses an seinem zweiten Eingang reproduziert wird und somit auch am Ausgangsterminal der Regelungsschaltung, wodurch die Betriebsspannung für den pinTWA und die Bias-Spannung für den zweiten Bias-Anschluss des Photodiodenchips geliefert werden.

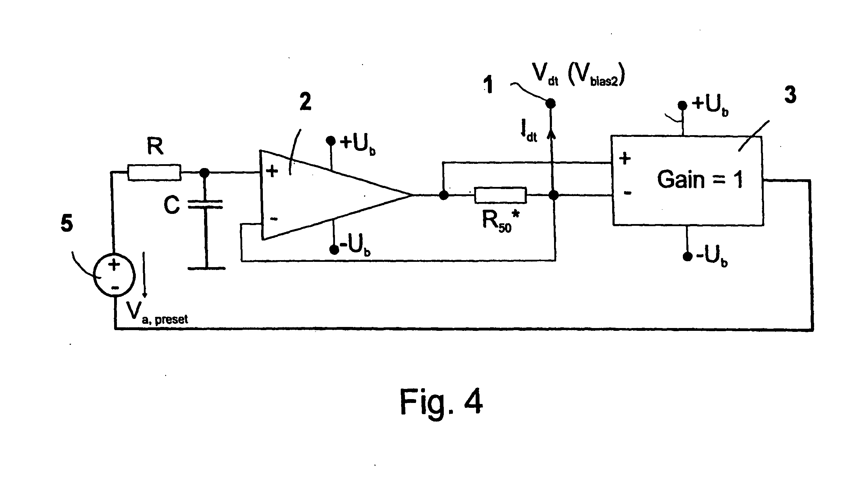

Bei einem vorteilhaften Ausführungsbeispiel, siehe Abb. 4, ist eine zusätzliche Offset-Spannungsquelle innerhalb der Regelschleife angeordnet, mit der das Ausgangspotential am HF-Ausgang des Photoempfängers auf eine Spannung ungleich 0V eingestellt werden kann, d.h. sie wirkt ausgangsspannungs-Offset-verschiebend.

Vorteilhafterweise ist in der Verbindungsleitung zwischen Differenzverstärker und einem Eingang des Spannungsfolgers ein RC-Tiefpass zum Begrenzen des Regelverhaltens des Regelkreises bis zu einer vorgegebenen Grenzfrequenz geschaltet.

Besonders vorteilhaft ist es, wenn die Mittel zur Messung einer Spannungsdifferenz und zum Reproduzieren der Spannungsdifferenz als Spannungspotential an den Ausgangsanschluss der Regelschleife, d.h. der Spannungsfolger und der Differenzverstärker mit einer bipolaren symmetrischen Betriebsspannungsquelle verbunden sind, da so aufgrund einer Spannungshalbierungsschaltung aus einer gemeinsamen Hauptspannungsversorgung die Versorgungsspannungssymmetrie für die Operationsverstärker auch beim Herauf- und Herunterfahren erhalten bleibt.

Ein Ausführungsbeispiel der Erfindung ist in der Zeichnung dargestellt und wird in der nachfolgenden Beschreibung näher erläutert. Es zeigen

Fig. 1     eine schaltungsgemäße Ausgestaltung eines pinTWA-Photoempfängers nach dem Stand der Technik,

Fig. 2     ein schematisches Schaltbild eines Photoempfängers nur mit einer pin-Photodiode und zwei Bias-Anschlüssen und

Fig. 3     die schaltungsgemäße Ausgestaltung der erfindungsgemäßen Regelungsschaltung nach einem ersten Ausführungsbeispiel,

Fig. 4   die schaltungsgemäße Ausgestaltung der erfindungsgemäßen Regelungsschaltung nach einem zweiten Ausführungsbeispiel und

Fig. 5   eine Schaltungsanordnung nach Fig. 4, bei der eine Spannungsquelle für $V_{a, preset}$ geerdet ist.

In Fig. 3 ist die schaltungsgemäße Ausgestaltung der erfindungsgemäßen Schaltungsanordnung zum Einstellen bzw. zum Regeln des Spannungspotentials am HF-Ausgang eines pin-Photoempfängers, der ein pin-Photodiodenempfängerchip nach Fig. 2 sein kann, aber auch ein pinTWA-Photoempfänger nach Fig. 1, dargestellt. Im Falle eines pinTWA-Photoempfängers, d.h. einer mit einem Wanderwellenverstärker auf einem Chip integrierte Photodiodenschaltung, wobei der Wanderwellenverstärker auch in Kaskodenschaltung vorgesehen sein kann, dient die Schaltungsanordnung nach Fig. 3 als positive Spannungsversorgung des pinTWA-Photoempfängers an seinem Eingangsanschlussterminal $V_{dt}$. Diese positive Spannungsversorgung soll beim Hochfahren und Herunterfahren selbsttätig mittels der erfindungsgemäßen Schaltung geregelt werden, wobei die negative Spannungsversorgung des Photoempfängers am negativen Anschlussterminal $V_{ss}$ vom Operator langsam veränderlich, ab 0 beginnend, vorgegeben wird.

Die Regelungsschaltung weist ein Ausgangsterminal 1 auf, welches entweder mit dem Anschluss für die positive Betriebsspannung des pinTWA-Photoempfängers $V_{dt}$ oder im Fall eines pin-Diodenchip-Photoempfängers mit dem zweiten Bias-Anschluss $V_{bias2}$ zu verbinden ist. Die Regelungsschaltung weist weiterhin einen Operationsverstärker 2 als Spannungsfolger und einen Differenzverstärker 3 auf, die in einer geschlossenen Regelschleife angeordnet sind. Weiterhin ist in dieser Regelschleife ein Nachbildungswiderstand $R_{50}^*$ geschaltet, der einerseits mit dem Ausgangsanschluss 1 der Regelschaltung und andererseits mit dem Ausgang des Operationsverstärkers 2 verbunden ist. Die beiden Seiten des Nachbildungswiderstandes $R_{50}^*$ sind für die Messung des Spannungsabfalls über diesen Widerstand an die positiven und negativen Eingänge des Differenzverstärkers 3 geführt, und der Ausgang des Differenzverstärkers 3, der eine Verstärkung von 1 aufweist, ist über ein RC-Glied, das einen Tiefpass darstellt, auf den positiven Eingang des Operationsverstärkers 2 geführt. Der negative Eingang des als Spannungsfolger geschalteten Operationsverstärkers ist mit dem Ausgangsanschluss 1 verbunden.

Für eine präzise Funktion der Regelung, üblicherweise mit dem Ziel eines Ausgangsspannungspotentials, das auf 0 V liegt, ist es wesentlich, dass der Widerstand $R_{50}^*$ an den im integrierten Photoempfänger vorliegenden Abschlusswiderstand $R_{50}$ nach Fig. 2 angeglichen wird. Im Falle eines pinTWA-Photoempfängers ist der Abschlusswiderstand $R_{50}$ der Drain-Leitungsabschlusswiderstand $R_{dt}$, der als bekannt vorausgesetzt wird, da er in der Chipvorcharakterisierung gemessen werden kann und üblicherweise in der 50-Ohm-Größenordnung liegt. Bei dem reinen pin-Photodiodenempfänger entsprechend Fig. 2 ist der Abschlusswiderstand $R_{50}$ am Ausgang des Photoempfängers zu erkennen. Schaltungsbedingt ist somit beim selben durchfließenden Strom, der hier mit $I_{dt}$ bezeichnet ist, der Spannungsabfall über $R_{50}$ bzw. $R_{dt}$ (im folgenden Text wird nur $R_{50}$ aufgeführt) im Photoempfänger identisch mit dem Spannungsabfall über den Nachbildungswiderstand $R_{50}^*$, da die extrem hochohmigen Eingänge von Instrumentenverstärkern (Differenz-Verstärkern) praktisch als stromlos betrachtet werden können, entsprechend der folgenden Gleichung

$$U(R_{50}^*) \ = \ I_{dt} \ \times \ R_{50}^* \ = \ U(R_{50}) \ = \ I_{dt} \ \times \ R_{50}$$

Somit würde eine Kontrolle bzw. Regelung der Betriebsspannung $V_{dt}$ am Spannungsversorgungsanschluss des pinTWA-Photoempfänges bzw. der Bias-Spannung $V_{bias2}$ (wie in Klammern in Fig. 3 gezeigt) am zweiten Bias-Anschluss des reinen pin-Diodenempfängers auf den Wert von $U(R_{50}^*) = U(R_{50})$ am HF-Ausgang des Photoempfängers auf exakt 0 führen, womit das Eingangspotential der Folgeelektronik, d.h. des Demultiplexers ebenfalls auf 0 V geregelt wird. Die Schaltung nach Fig. 3 gewinnt den Spannungsabfall $U(R_{50}) = U(R_{50}^*)$ über die Spannungsdifferenzmessung am Nachbildungswiderstand $R_{50}^*$ mit Hilfe des Differenzverstärkers 3 mit dem Verstärkungsfaktor 1. Sein Ausgangssignal wird über die geschlossene Regelschleife auf den Eingang des Spannungsfolger-Operationsverstärkers 2 gegeben, der mittels seiner eigenen Gegenkopplung das Potential des Ausgangssignals exakt an seinem Minuseingang reproduziert und dies ungeachtet der Höhe des Spannungsabfalls $U(R_{50}^*)$. Dieses Potential bzw. die Spannung liegt auch am Ausgangsanschluss der Regelungsschaltung und speist somit als positive Betriebsspannung den pinTWA-Photoempfänger oder bildet die Bias-Spannung des zweiten Bias-Anschlusses des pin-Diodenempfängers.

Der Operationsverstärker 2 ist somit so geschaltet, dass er bei einem pinTWA-Photoempfänger bei langsam ins Negative gesteigertem $V_{ss}$-Potential, unabhängig von der Höhe des Drainstroms $I_{dt}$ des Wanderwellenverstärkers stets das Spannungspotential am Ausgangsanschluss 1 der Regelschaltung exakt soweit anhebt, dass über den gleich hohen Spannungsabfall an dem Drain-Abschlusswiderstand $R_{dt}$ der HF-Ausgang des Wanderwellenverstärkers auf $V_a$ = 0 V geregelt wird.

In entsprechender Weise wird bei einem Photoempfänger entsprechend Fig. 2 durch interne Messung des Photostroms und Anpassung der Bias-Spannung $V_{bias2}$ stets auf ein konstantes Potential am HF-Ausgang SIG von 0 V geregelt, ungeachtet der Höhe des Photostroms.

Das RC-Tiefpassglied am positiven Eingang des Operationsverstärkers 2 bewirkt, dass das durch die Schaltungsanordnung nach Fig. 3 vorgegebene Regelverhalten von Gleichspannung ab nur bis zu einer Grenzfrequenz $f_u$ aufrechterhalten wird, oberhalb derer dann der Betriebsfrequenzbereich des Photoempfängers beginnt, daher liegt $f_u$ typisch im Bereich einiger KHz. Diese KHz-Grenze kann leicht den Erfordernissen des Betriebsübertragungsfrequenzbereichs des Photoempfängers angepasst werden.

Im Falle eines pinTWA-Photoempfängers kann sich somit der Anwender auf das Herauf- oder Herunterfahren einer einzigen Betriebsspannung, hier die negative Betriebsspannung $-V_{ss}$, die typischerweise zwischen -2 V und 0 V liegt, konzentrieren, wobei die Regelungsschaltung nach Fig. 3 für praktisch beliebig vorgebbare negative Spannungswerte von $-V_{ss}$ stets die dazu passende positive Spannung $V_{dt}$ erzeugt, die den HF-Ausgang bzw. den Demultiplexer-Eingang stets auf eine Gleichspannung $V_a = 0$ V einstellt.

Dieses günstige Ausregelverhalten am HF-Ausgang ist völlig unabhängig von der Nichtlinearität der Ausgangskennlinien der im Wanderwellenverstärker verwendeten Transistoren, da ausschließlich anhand des von der Regelschaltung kontinuierlich gemessenen Betriebsstroms $I_{dt}$ geregelt wird. Der HF-Ausgang wird somit auch für beliebig variierende Photoströme im mV-Bereich genau auf 0 V gehalten, wo seine üblicherweise günstigste Schaltschwelle liegt.

Selbstverständlich zeigt Fig. 3 lediglich eine Prinzipschaltung, bei der Realisierung werden diverse Schaltungselemente hinzugefügt, die dafür sorgen, dass der Operationsverstärker 2 schwingungsfrei und ESD-geschützt, entsprechend der Differenzverstärker 3 arbeiten kann.

Die Betriebsspannungsversorgungen $+U_b$ und $-U_b$ des Operationsverstärkers 2 und des Differenzverstärkers 3, der üblicherweise ebenfalls mit Operationsverstärkern aufgebaut ist, können günstig nur aus einer einzigen Spannung abgeleitet werden, wobei aus einem Netzteil mittels bekannter Spannungshalbierungsschaltungen symmetrische Betriebsspannungen abgeleitet werden können. Diese gewollte Betriebsspannungssymmetrie bleibt auch bei Variieren der Spannung der gemeinsamen Spannungsquelle, insbesondere bei deren Ein- und Ausschalten erhalten, d.h. die beiden Spannungen $+U_b$ und $-U_b$, üblicherweise $\pm 12$ V, können dann exakt synchron herauf- und heruntergefahren werden. Somit werden auch keine Spannungsabweichungen am HF-Ausgang während der Ein- und Ausschaltsequenzen auftreten.

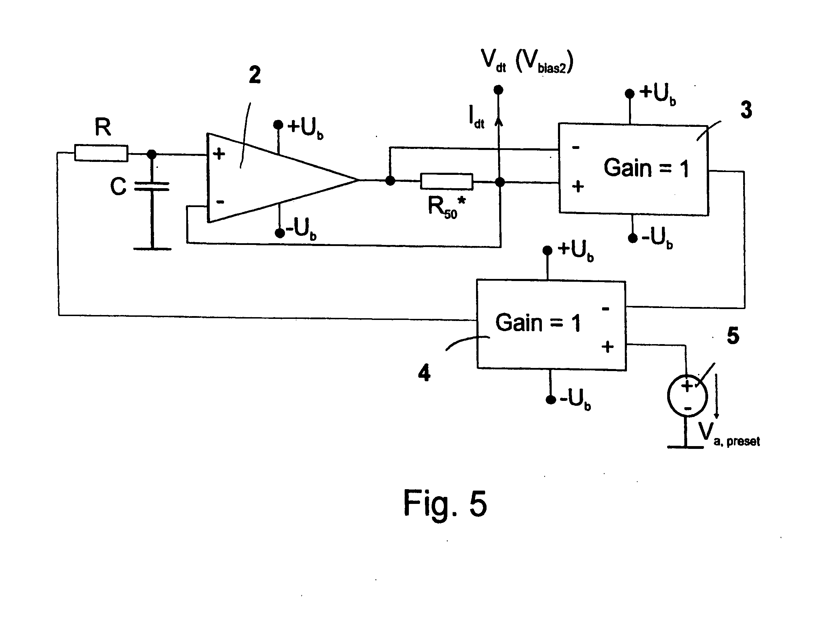

In Fig. 4 und Fig. 5 ist eine weitere Ausgestaltung der Regelschaltung nach Fig. 3 dargestellt, die dazu dient, die Ausgangsgleichspannung $V_a$ nicht auf $V_a = 0$ V einzustellen, sondern auf einen vorgegebenen Wert, der mit $V_a = V_{a, preset}$ bezeichnet wird und der beispielsweise zwischen $\pm 100$ mV liegen kann. Dazu ist in die Rückführungsleitung vom Differenzverstärker 3 zum Operationsverstärker 2 eine Spannungsquelle 5 geschaltet, die das Photoempfänger-Ausgangspotential bzw. das Potential am Eingang der Folgeelektronik $V_a$ um $V_a = V_{a,preset}$ verschiebt.

In Fig. 4 ist die Spannungsquelle 5 "floatend" geschaltet, während sie in Fig. 5 einseitig auf Erde liegt und mit einem Eingang eines weiteren Differenzverstärkers 4 mit Verstärkung 1 verbunden ist, an dessen zweitem, negativen Eingang das Ausgangssignal des Differenzverstärkers 3 liegt. Der Ausgang des weiteren Differenzverstärkers 4 ist mit dem Widerstand R verbunden, der am positiven Eingang des Operationsverstärkers 2 angeschlossen ist. Der gesamte Regelungssinn ist derselbe wie in der Fig. 4, allerdings mit dem schaltungstechnischen Vorteil, dass die Offsetspannung $V_{a, preset}$ nun massebezogen in die Regelungsschaltung eingespeist werden kann.

Die Spannung $V_{a, preset}$ kann aus der bipolaren Spannungsversorgung des Operationsverstärkers 2 und des Differenzverstärkers 3 bzw. 4 durch potentiometrische Spannungsteilung gewonnen werden.

**Patentansprüche**

1. Schaltungsanordnung zum Einstellen eines Ausgangspotentials am HF-Ausgang eines pin-Photoempfängers, der sich in Gleichspannungskopplung mit einem nachfolgenden Elektronikschaltkreis befindet, auf ein bestimmtes Potential, wobei an den pin-Photoempfänger eine über einen ohmschen Abschlusswiderstand das Ausgangspotential beeinflussende Versorgungsspannung anlegbar ist,

   **gekennzeichnet durch**

   eine einen Ausgangsanschluss (1) aufweisende Regelschleife zum Erzeugen und Regeln der Versorgungsspannung, wobei die Regelschleife einen ohmschen Nachbildungswiderstand ($R_{50}$*), der an den ohmschen Abschlusswiderstand ($R_{50}$) angeglichen ist, und Mittel zur Messung einer Spannungsdifferenz über den Nachbildungswiderstand ($R_{50}$*) und zum Reproduzieren der Spannungsdifferenz als Spannungspotential am Ausgangsanschluss (1) der Regelschleife aufweist.

2. Schaltungsanordnung nach Anspruch 1, **dadurch gekennzeichnet, dass** die geschlossene Regelschleife einen Spannungsfolger (2), den Nachbildungswiderstand ($R_{50}$*) und einen Differenzverstärker (3) zum Messen der Spannungsdifferenz aufweist.

3. Schaltungsanordnung nach Anspruch 1 oder 2, **dadurch gekennzeichnet, dass** die Mittel zur Messung einer Spannungsdifferenz und zum Reproduzieren der Spannungsdifferenz einen bzw. den Differenzverstärker (3) und einen bzw. den Spannungsfolger (2) aufweisen, wobei das Ausgangssignal des Differenzverstärkers (3) dem Spannungsfolger (2) an einem seiner Eingänge zuführbar ist und der andere Eingang mit dem Ausgangsanschluss (1) der Regelschleife verbunden ist.

4. Schaltungsanordnung nach Anspruch 2 oder Anspruch 3, **dadurch gekennzeichnet, dass** der Nachbildungswiderstand ($R_{50}$*) einerseits mit dem Ausgang des Spannungsfolgers (2) und andererseits mit dem Ausgangsanschluss (1) verbunden ist.

5. Schaltungsanordnung nach einem der Ansprüche 2 bis 4, **dadurch gekennzeichnet, dass** ein RC-Tiefpass in die Verbindungsleitung vom Ausgang des Differenzverstärkers (3) zu einem Eingang des Spannungsfolgers (2) zum Begrenzen des Regelverhaltens des Regelkreises bis zu einer vorgegebenen Grenzfrequenz geschaltet ist.

6. Schaltungsanordnung nach einem der Ansprüche 1 bis 5, **dadurch gekennzeichnet, dass** die Mittel zur Messung einer Spannungsdifferenz und zum Reproduzieren der Spannungsdifferenz als Spannungspotential am Ausgangsanschluss (1) der Regelschleife mit einer bipolaren symmetrischen Betriebsspannungsquelle verbunden sind.

7. Schaltungsanordnung nach einem der Ansprüche 1 bis 6, **dadurch gekennzeichnet, dass** die Mittel zur Messung einer Spannungsdifferenz und zum Reproduzieren der Spannungsdifferenz als Spannungspotential am Ausgangsanschluss (1) eine zusätzliche Offset-Spannungsquelle (5) innerhalb der Regelschleife aufweisen.

8. Schaltungsanordnung nach Anspruch 7, **dadurch gekennzeichnet, dass** die Offset-Spannungsquelle (5) auf schwebendem Potential oder einseitig geerdet und über einen weiteren Differenzverstärker (4) in der Verbindungsleitung zwischen dem Differenzverstärker (3) und dem Spannungsfolger (2) angeordnet ist.

9. Schaltungsanordnung nach einem der Ansprüche 2 bis 8, **dadurch gekennzeichnet, dass** der bzw. die Differenzverstärker (3, 4) einen Verstärkungsfaktor von 1 aufweist/aufweisen.

10. Photoempfängeranordnung mit einem pin-Photoempfänger mit mindestens einer Photodiode und einer Schaltungsanordnung zum Einstellen des Ausgangspotentials ($V_a$; $V_{a,preset}$) am HF-Ausgang des pin-Photoempfängers nach einem der Ansprüche 1 bis 9.

11. Photoempfängeranordnung nach Anspruch 10, **dadurch gekennzeichnet, dass** der pin-Photoempfänger ein pin-Wanderwellenverstärker-Photoempfänger ist, wobei die zu erzeugende und zu regelnde Spannung der Spannungsversorgung die positive Betriebsspannung ($V_{dt}$) des Wanderwellenverstärkers ist und die Schaltungsanordnung zum Einstellen des Ausgangspotentials mit dem Anschluss für dessen Betriebsspannung ($V_{dt}$) verbunden ist.

12. Photoempfängeranordnung nach Anspruch 10, **dadurch gekennzeichnet, dass** der pin-Photoempfänger einen ersten Bias-Anschluss ($V_{bias1}$) zur Versorgung der im pin-Photoempfänger enthaltenen Photodiode mit einer Sperrspannung und einen zweiten Bias-Anschluss ($V_{bias2}$) zum Einstellen des Spannungspotentials ($V_a$; $V_{a,preset}$) am HF-Ausgang aufweist, wobei die zu erzeugende und zu regelnde Spannung der Spannungsversorgung der Schaltungsanordnung zum Einstellen des Ausgangspotentials die an den zweiten Bias-Anschluss ($V_{bias2}$) zu legende Bias-Spannung ist.

13. Photoempfängeranordnung nach einem der Ansprüche 10 bis 11, **dadurch gekennzeichnet, dass** der DCgekoppelte nachgeschaltete Elektronikschaltkreis ein Demultiplexer, ein Verstärker oder ein Sampling-Schaltkreis ist.

**Claims**

1. A circuit arrangement for setting an output potential at the HF output of a pin-photoreceiver which is located in the d.c. voltage coupling to a subsequent electronics circuit, to a certain potential, wherein a supply voltage influencing the output potential via an ohmic terminal resistance may be applied to the pin photoreceiver,
   **characterised by**
   a control loop for producing and closed-loop control of the supply voltage and which comprises an output terminal (1), wherein the control loop comprises a ohmic balancing resistance ($R_{50}$*) which is adapted to the ohmic terminal resistance ($R_{50}$), and means for measuring a voltage difference across a balancing resistance ($R_{50}$*) and for repro-

7

ducing the voltage difference as a voltage potential at the output terminal (1) of the control loop.

2. A circuit arrangement according to claim 1, **characterised in that** the closed control loop comprises a unity-gain amplifier (2), the balancing resistance ($R_{50}$*) and a differential amplifier (3), for measuring the voltage difference.

3. A circuit arrangement according to claim 1 or 2, **characterised in that** the means for measuring a voltage difference and for reproducing a voltage difference comprise a or the differential amplifier (3) and a or the unity-gain amplifier (2), wherein the output signal of the differential amplifier (3) may be fed to the unity-gain amplifier (2) at one of its inputs, and the other input is connected to the output terminal (1) of the control loop.

4. A circuit arrangement according to claim 2 or claim 3, **characterised in that** the balancing resistance ($R_{50}$*) on the one hand is connected to the output of the unity-gain amplifier (2), and on the other hand to the output terminal (1).

5. A circuit arrangement according to one of the claims 2 to 4, **characterised in that** an RC low-pass is connected into the connection line from the output of the differential amplifier (3) to an input of the unity-gain amplifier (2), for limiting the closed-loop control behaviour of the regulating circuit up to a predefined limit frequency.

6. A circuit arrangement according to one of the claims 1 to 5, **characterised in that** the means for measuring a voltage difference and for reproducing the voltage difference as a voltage potential at the output terminal (1) of the control loop are connected to a bipolar symmetrical operating voltage source.

7. A circuit arrangement according to one of the claims 1 to 6, **characterised in that** the means for measuring a voltage difference and for reproducing the voltage difference as a voltage potential at the output terminal (1) comprise an additional offset voltage source (6) within the control loop.

8. A circuit arrangement according to claim 7, **characterised in that** the offset voltage source (5) is earthed on a floating potential or earthed at one side and via a further differential amplifier (4) is arranged in the connection line between the differential amplifier (3) and the unity-gain amplifier (2).

9. A circuit arrangement according to one of the claims 2 to 8, **characterised in that** the differential amplifier or amplifiers (3, 4) has/have an amplification factor of 1.

10. A photoreceiver arrangement with a pin-photodiode receiver with at least one photodiode and with a circuit arrangement for setting the output potential ($V_a$; $V_{a,\ preset}$) at the HF output of the pin photoreceiver, according to one of the claims 1 to 9.

11. A photoreceiver arrangement according to claim 10, **characterised in that** the pin photoreceiver is a pin travelling wave amplifier photoreceiver, wherein the voltage of the voltage supply which is to be produced and controlled with a closed loop is the positive operating voltage ($V_{dt}$) of the travelling wave amplifier, and the circuit arrangement for setting the output potential is connected to the terminal for its operating voltage ($V_{dt}$).

12. A photoreceiver according to claim 10, **characterised in that** the pin-photoreceiver comprises a first bias terminal ($V_{bias1}$) for supplying the photodiode contained in the pin photoreceiver with blocking voltage, and a second bias terminal ($V_{bias2}$) for setting the voltage potential ($V_a$; $V_{a,\ preset}$) at the HF output, wherein the voltage of the voltage supply of the circuit arrangement for setting the output potential and which is to be produced and closed-loop controlled, is the bias voltage to be applied to the second bias terminal ($V_{bias2}$).

13. A photoreceiver arrangement according to one of the claims 10 to 11, **characterised in that** d.c.-coupled electronics circuit which is connected afterwards in series is a demultiplexer, an amplifier or a sampling circuit.

**Revendications**

1. Circuiterie destinée au réglage d'un potentiel de sortie à la sortie HF d'un photorécepteur PIN, qui se trouve couplé en tension continue à un circuit électronique monté en aval, à un potentiel déterminé, une tension d'alimentation influençant le potentiel de sortie par le biais d'une résistance de terminaison ohmique pouvant être appliquée au photorécepteur PIN,
**caractérisée par**

une boucle de régulation comprenant un branchement de sortie (1) et servant à produire et réguler la tension d'alimentation, la boucle de régulation comprenant une résistance ohmique d'équilibrage ($R_{50}$*) qui est adaptée à la résistance de terminaison ohmique ($R_{50}$), et des moyens pour mesurer une différence de tension par le biais de la résistance d'équilibrage ($R_{50*}$) et pour reproduire la différence de tension en tant que potentiel de tension sur le branchement de sortie (1) de la boucle de régulation.

2. Circuiterie selon la revendication 1, **caractérisée en ce que** la boucle de régulation fermée comprend un suiveur de tension (2), la résistance d'équilibrage ($R_{50}$*) et un amplificateur de différence (3) servant à la mesure de la différence de tension.

3. Circuiterie selon la revendication 1 ou 2, **caractérisée en ce que** les moyens pour mesurer une différence de tension et pour reproduire la différence de tension comprennent respectivement un ou ledit amplificateur de différence (3) et respectivement un ou ledit suiveur de tension (2), le signal de sortie de l'amplificateur de différence (3) pouvant être amené à l'une des entrées du suiveur de tension (2), l'autre entrée étant reliée au branchement de sortie (1) de la boucle de régulation.

4. Circuiterie selon la revendication 2 ou 3, **caractérisée en ce que** la résistance d'équilibrage ($R_{50*}$) est reliée d'un côté à la sortie du suiveur de tension (2) et, d'un autre côté, au branchement de sortie (1).

5. Circuiterie selon l'une quelconque des revendications 2 à 4, **caractérisée en ce qu'**un passe-bas RC est monté dans la ligne de liaison de la sortie de l'amplificateur de différence (3) à une entrée du suiveur de tension (2) afin de limiter le comportement en régulation du circuit de régulation jusqu'à une fréquence limite prédéfinie.

6. Circuiterie selon l'une quelconque des revendications 1 à 5, **caractérisée en ce que** les moyens pour mesurer une différence de tension et pour reproduire la différence de tension en tant que potentiel de tension sur le branchement de sortie (1) de la boucle de régulation sont reliés à une source de tension de service bipolaire symétrique.

7. Circuiterie selon l'une quelconque des revendications 1 à 6, **caractérisée en ce que** les moyens pour mesurer une différence de tension et pour reproduire la différence de tension en tant que potentiel de tension sur le branchement de sortie (1) comprennent une source de tension de décalage (5) supplémentaire à l'intérieur de la boucle de régulation.

8. Circuiterie selon la revendication 7, **caractérisée en ce que** la source de tension de décalage (5) est à un potentiel flottant ou est mise à la terre sur un côté et est disposée par le biais d'un autre amplificateur de différence (4) dans la ligne de liaison entre l'amplificateur de différence (3) et le suiveur de tension (2).

9. Circuiterie selon l'une quelconque des revendications 2 à 8, **caractérisée en ce que** respectivement le ou les amplificateurs de différence (3, 4) présente/présentent un facteur d'amplification de 1.

10. Agencement photorécepteur pourvu d'un photorécepteur PIN avec au moins une photodiode et une circuiterie servant à régler le potentiel de sortie ($V_a$; $V_{a,preset}$) à la sortie HF du photorécepteur PIN selon l'une quelconque des revendications 1 à 9.

11. Agencement photorécepteur selon la revendication 10, **caractérisé en ce que** le photorécepteur PIN est un amplificateur PIN à onde progressive, la tension à produire et à réguler de la tension d'alimentation étant la tension de service positive ($V_{dt}$) de l'amplificateur à onde progressive et la circuiterie pour le réglage du potentiel de sortie étant reliée au branchement pour la tension de service ($V_{dt}$) dudit amplificateur.

12. Agencement photorécepteur selon la revendication 10, **caractérisé en ce que** le photorécepteur PIN comprend un premier branchement de polarisation ($V_{bias1}$) servant à l'alimentation de la photodiode, comprise dans le photorécepteur PIN, avec une tension d'arrêt et un deuxième branchement de polarisation ($V_{bias2}$) servant à régler le potentiel de tension ($V_a$; $V_{a,preset}$) à la sortie HF, la tension à produire et à réguler de la tension d'alimentation de la circuiterie pour le réglage du potentiel de sortie étant la tension de polarisation présente sur le deuxième branchement de polarisation ($V_{bias2}$).

13. Agencement photorécepteur selon l'une quelconque des revendications 10 à 11, **caractérisé en ce que** le circuit électronique monté en aval et couplé en tension continue est un démultiplexeur, un amplificateur ou un circuit d'échantillonnage.

Fig. 1

Fig. 2

EP 2 471 202 B1

Fig. 3

Fig. 4

EP 2 471 202 B1

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **BACH et al.** Design and Fabrication of 60 Gb/s InP-Based Monolithic Photoreceiver OEICs and Modules. *IEEE Journal of Selected Topics in Quantum Electronics,* 2002, vol. 8 (6), 1445-1450